# EUROPÄISCHE PATENTSCHRIFT

(11) **EP 0 396 641 B1**
(45) Veröffentlichungstag und Bekanntmachung des Hinweises auf die Patenterteilung: **21.09.1994**
(21) Anmeldenummer: 89907736.6
(22) Anmeldetag: 12.07.1989
(51) Int. Cl.: H01L 23/31, H01L 23/04, H01L 25/065

(54) **BESCHLEUNIGUNGSFESTE VERPACKUNG FÜR INTEGRIERTE SCHALTUNGEN UND VERFAHREN ZU IHRER HERSTELLUNG**
ACCELERATION-RESISTANT PACKAGING FOR INTEGRATED CIRCUITS AND PROCESS FOR MANUFACTURING IT
CONDITIONNEMENT RESISTANT AUX ACCELERATIONS POUR CIRCUITS INTEGRES ET PROCEDE DE FABRICATION

(30) Priorität: 10.11.1988 DE 3838085
(43) Veröffentlichungstag der Anmeldung: 14.11.1990
(73) Patentinhaber: Rheinmetall Industrie GmbH, 40880 Ratingen (DE)
(72) Erfinder: OPITZ, Hans-Peter, D-4030 Ratingen 1 (DE)
(86) Internationale Anmeldenummer: EP8900806
(87) Internationale Veröffentlichungsnummer: WO9005379

(56) Entgegenhaltungen:
- EP-A- 0 122 687
- EP-A- 0 277 606
- PATENT ABSTRACTS OF JAPAN, Band 10, Nr. 179 (E-414)(2235), 24. Juni 1986 ; & JP-A-6127663

## Beschreibung

Die Erfindung betrifft beschleunigungsfeste Verpackungen für integrierte Schaltungen und bezieht sich ferner auf ein Verfahren zu ihrer Herstellung.

Normalerweise werden integrierte Schaltungen in einem Plastik- oder Keramikgehäuse verpackt. Die Anschlüsse werden je nach Gehäusetyp unterschiedlich realisiert, wobei üblicherweise Bonddrähte von den Lötpads nach unten bzw. nach der Seite herausgeführt werden. Derartig verpackte Schaltungen sind allerdings in Geschossen nicht einsetzbar. Denn aufgrund der hohen auftretenden Beschleunigung kommt es bei Keramikgehäusen zu Mikrobrüchen bzw. unter Umständen zur völligen Zerstörung. Bei Plastikgehäusen kommt es zum Abriß von Bonddrähten bzw. führen Vergasungsvorgänge des Plastikmaterials dazu, daß die verlangte Lagerfähigkeit nicht militärischen Spezifikationen entspricht. Außerdem ist häufig die Bauraumbeanspruchung bekannter Verpackungen für die Verwendung in Geschossen zu groß.

Es ist daher bereits bekannt geworden, integrierte Schaltungen in Geschossen zu vergießen oder spezielle Metallgehäuse zu verwenden.

Das Vergießen von Schaltungen hat allerdings verschiedene Nachteile, wie ein hohes Gewicht, schlechte Prüfbarkeit der Schaltung, hohe Temperatur beim Vergießen, die Schäden, hohe Kosten, relativ große Baugröße etc. verursachen können.

Auch bei der Verwendung von Metallgehäusen ergeben sich relativ große Baugrößen und hohe Kosten sowie eine schlechte Vibrationsdämpfung.

Aus der JP-A-61 27 663 ist es bekannt, integrierte Schaltungen zwischen Folien anzuordnen, um die Bauelemente gegen Feuchtigkeit zu schützen. Dabei werden die die integrierten Schaltungen umschließenden Folien umfangseitig auf den gegenüberliegenden Flächen einer Trägerfolie befestigt. Die Trägerfolie dient außerdem als Träger für die von den integrierten Schaltungen nach außen führenden elektrischen Leitungen. Einen Hinweis auf die Verwendung derartiger Anordnung für beschleunigungsfeste Verpackungen von integrierten Schaltungen läßt sich dieser Schrift nicht entnehmen. Außerdem erhöht die Verwendung einer zentralen Trägerfolie die Herstellkosten und das Gewicht einer derartigen Verpackung, ohne daß sich hieraus ein besonderer Vorteil hinsichtlich der Beschleunigungsfestigkeit derartiger Verpackungen ableiten ließe.

Schließlich ist aus der EP-A-0 277 606 eine Verpackung für integrierte Schaltungen bekannt, bei der die Schaltungen zwischen einer Folie und einem starren Trägermaterial, z.B. aus Glas, angeordnet sind. Die Folie wird an dem Träger mit Hilfe eines Rahmens befestigt.

Derartige Verpackungen weisen die Nachteile auf, daß sie relativ aufwendig herstellbar, schwer und in Geschossen nicht verwendet werden können, weil das Trägermaterial in der Regel nicht abschußfest ist.

Der vorliegenden Erfindung liegt daher die Aufgabe zugrunde, eine beschleunigungsfeste Verpackung zu entwickeln, die eine möglichst kleine Baugröße aufweist und deren Beschleunigungsfestigkeit über 30.000 g beträgt. Außerdem soll die Vibration gedämpft und die Kosten vertretbar sein.

Die vorstehende Aufgabe wird erfindungsgemäß durch die Merkmale des kennzeichnenden Anspruchs 1 gelöst.

Der Grundgedanke der Erfindung besteht also darin, als Verpakkung nicht ein Gehäuse aus Kunststoff, Keramik oder Metall zu verwenden oder die Schaltung zu vergießen, sondern die Schaltungen zwischen zwei Folien aus schockfestem elastischen Material anzuordnen und die Folien miteinander umfangseitig in einen Spannrahmen einzuspannen, aus dem seitlich die Anschlüsse der integrierten Schaltungen herausragen.

Die Folien schützen die integrierten Schaltungen vor Umwelteinflüssen, wie Vibrationen, Strahlung und -bei geeigneter Materialwahl- auch vor Temperaturschwankungen.

Aufgrund der verwendeten Materialien ist wegen der geringen Masse und der Elastizität die volle Beschleunigungsfestigkeit gegeben, im Gegensatz zu Plastik oder Keramikverpackungen. Weiterhin besteht ein wesentlicher Vorteil der erfindungsgemäßen Verpackung in der großen Gewichtsersparnis sowie die Möglichkeit, auch mehrere integrierte Schaltungen in einem Spannrahmen einzubringen.

Nähere Einzelheiten und weitere Vorteile der Erfindung werden im folgenden anhand von Ausführungsbeispielen mit Hilfe von Figuren erläutert.

Es zeigen:
- Fig. 1: schematisch eine Explosionsdarstellung einer erfindungsgemäßen Verpackung;
- Fig. 2: die in Fig. 1 dargestellte Verpackung zusammengebaut;
- Fig. 3: ein weiteres Beispiel einer schematisch dargestellten erfindungsgemäßen Verpackung, wobei die integrierten Schaltungen in mehreren Lagen angeordnet sind; und
- Fig. 4: die Anordnung der Verpackung nach Fig. 3 in einem Geschoß.

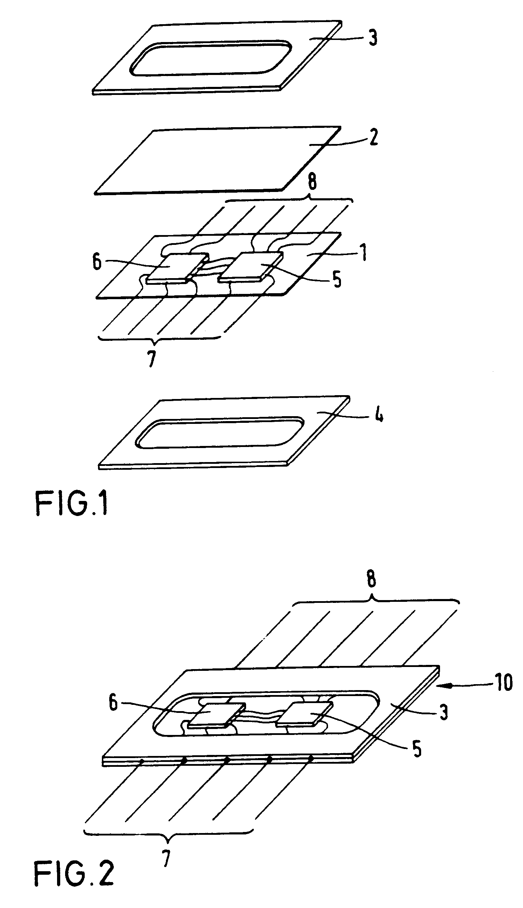

In Fig. 1 ist mit 1 eine erste Folie, mit 2 eine zweite Folie und mit 3 und 4 ein oberes und ein unteres Rahmenteil bezeichnet.

Auf der ersten Folie 1 befinden sich zwei integrierte Schaltungen 5 und 6, die mit den Anschlußdrähten 7 und 8 verbunden sind.

Fig. 2 zeigt die in Fig. 1 wiedergegebenen Einzelteile zusammengebaut. Dabei wurde die gesamte Verpackung mit dem Bezugszeichen 10 versehen.

Im folgenden wird kurz auf das Verfahren zur Herstellung der in den Fig. 1 und 2 dargestellten Verpackung eingegangen:
Auf die Folie 1 werden die integrierten Schaltungen 5 und 6 aufgebracht und z. B. mittels Klebung befestigt. Von außen herangeführte Anschlußdrähte 7 und 8 werden beidseitig ebenfalls per Klebung befestigt. Im nächsten Schritt werden sämtliche Verbindungen durch Bonden der Lötpads (nicht dargestellt) der integrierten Schaltungen 5 und 6 hergestellt. Anschließend wird die zweite Folie 2 auf die erste Folie 1 mit den integrierten Schaltungen 5 und 6 gelegt. Die Folien können dann an ihren Rändern verklebt werden. Von oben wird im nächsten Schritt das Foliensystem mit dem Rahmenteil 3 und von unten mit dem Rahmenteil 4 versehen und der gesamte Rahmen verklebt. Von außen zugänglich sind nur noch die Anschlußdrähte 7 und 8, die über die Bondverbindungen den Kontakt zu den integrierten Schaltungen herstellen.

Vor dem Verkleben der Folien 1 und 2 kann es zweckmäßig sein, das Folieninnere zu evakuieren oder mit einem inerten Gas zu versehen. Hierdurch werden sämtliche Luftverunreinigungen innerhalb der Folien ausgeschlossen bzw. zuminest stark reduziert, wodurch sich die Lagerfähigkeit eines derartigen Aufbaus erhöht, da die Wahrscheinlichkeit von langsamen chemischen oder physikalischen Reaktionen herabgesetzt wird.

Anstatt die integrierten Schaltungen 5 und 6 direkt auf die Folie 1 aufzubringen, hat es sich als vorteilhaft erwiesen, zunächst auf die Folien 1 und 2 Leiterbahnschichten aufzubringen und auf diesen Schichten dann die integrierten Schaltungen 5 und 6 anzuordnen. Für das Aufbringen der Leiterbahnschichten sind zwei unterschiedliche Methoden bekannt, eine Dünnfilm- sowie eine Dickfilmtechnik. Bei der Dünnfilmtechnik werden die Leiterbahnen in bekannter Weise durch Aufdruck und Ätzverfahren auf der Folie fixiert, die Leiterbahnen also durch Silberleitklebebahnen ersetzt. Bei der Dickfilmtechnik werden zunächst Isolator bzw. Leiterbahnpasten auf die Folie aufgebracht und in einem letzten Schritt durch einen Brennvorgang vefestigt (Temperatur kleiner 150°C).

Die integrierten Schaltungen sind anschließend so auf den Kontaktierungspunkten der Schichtschaltungen unterzubringen, daß die vorgesehenen Lötpads der IC's direkt mit den Kontaktierungspunkten verbunden werden können. Dies kann entweder durch die Lötung eines kurzen Bonddrahtes oder durch Aufbringen eines Lötpunktes, Erwärmung und Anpressen der Folie geschehen. Die erste Version eignet sich für die Kontaktierung, wenn die Leitungsschichten auf Folie 1 untergebracht sind und die integrierten Schaltungen mit ihrer planaren Funktionsschicht nach Folie 2 hin orientiert aufgebracht werden. Die zweite Version eignet sich bei Orientierung der Schichtschaltung zur Funktionsschicht des IC's hin.

Bei der praktischen Herstellung der Verpackung sollte beachtet werden, daß bei jedem Fertigungsschritt zur Vermeidung von Ausschuß eine Funktionsprüfung vorzusehen ist.

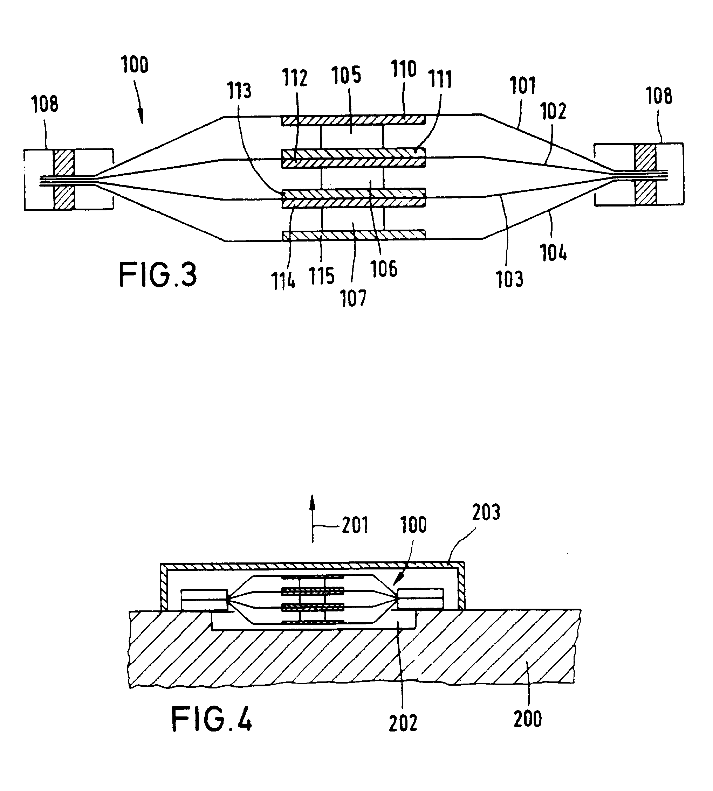

Neben der Möglichkeit, integrierte Schaltungen in einer Ebene einzusetzen, eröffnet die erfindungsgemäße Folienmethode den Weg einer mehrdimensionalen Verkettung der integrierten Schaltungen vorzusehen. Man verwendet dann statt zweier übereinanderliegender Folien deren drei oder mehr und sieht in den Zwischenschichten jeweils eine Lage integrierter Schaltungen vor. Ein entsprechendes Ausführungsbeispiel zeigt Fig. 3:

Dabei wurde die Verpackung mit 100, die Folien mit 101-104, die, nur schematisch dargestellten, integrierten Schaltungen mit 105 - 107, der Spannrahmen mit 108 und die in Dickfilmtechnik aufgebrachten und ebenfalls nur schematisch dargestellten Schichtschaltungen mit 110 - 115 bezeichnet.

Die Aufgabe der Schichtschaltungen 110 - 115 besteht darin, die integrierten Schaltungen miteinander zu verbinden. So kann beispielsweise die Schichtschaltung 110 über die Folieneinspannung 108 die Verbindung zu 111 bzw. 112 herstellen und deckt zudem die notwendigen Lötpads der IC's 105 ab, um deren Signale nach außen bzw. an die anderen Schaltungen weiterzuleiten. Hierbei sollte Schaltung 111 mit der Schaltung 112 über die Folie verbunden sein. In derselben Weise können die Verbindungen 112, 106 und 113 bzw. 114, 107 und 115 ausgebildet sein, so daß sämtliche integrierten Bauteile über die Einspannung 108 bzw. die Schichtschaltungen 110 - 115 miteinander in Verbindung stehen.

Zweckmäßigerweise werden die erfindungsmäß verpackten integrierten Schaltungen in den jeweiligen Geschoß so gelagert, daß die maximale Krafteinwirkung in einem 90°-Winkel auf die Einspannung trifft. Die gesamte Folienstruktur sollte so eingebaut verden, daß Schwingungen kleiner Auslenkung mit kleiner Dehnung der Folie möglich sind, bei großen Beschleunigungen jedoch eine Unterstützungsfläche vorhanden ist, um ein Reißen der Folien zu verhindern. Hierzu können die Spannrahmen sowohl im Standardgeäuse untergebracht als auch direkt verwendet werden.

Ein entsprechendes Ausführungsbeispiel zeigt Fig. 4. Dabei ist mit 200 der Boden eines Geschosses gekennzeichnet, welcher sich in Richtung des Pfeiles 201 bewegt.

In deren Boden 200 ist eine Aussparung 202 vorgesehen, in die teilweise die Verpackung 100 reicht, so daß bei großen Beschleunigungen der Boden 200 als Unterstützungsfläche wirkt. In dem dargestellten Ausführungsbeispiel ist die Verpackung 100 mit einer Schutzabdeckung 203 versehen.

Die Folien 1, 2; 101 - 104 sollen aus schockfestem, elastischen Material (z. B. Polyimide)) bestehen, auf welchem die Leiterbahnen befestigt bzw. aufgebracht werden können.

### Bezugszeichenliste

- 1: erste Folie
- 2: zweite Folie
- 3: oberer Rahmenteil
- 4: unterer Rahmenteil
- 5: integrierte Schaltung
- 6: integrierte Schaltung
- 7: Anschlußdraht
- 8: Anschlußdraht
- 10: Verpackung

100 Verpackung, mehrlagige Verpackung
101)
102) Folien
103)
104)
105)
106) integrierte Schaltung
107)

108 Rahmen
110)
111)
112) in Dickfilmtechnik aufgebrachte Schichtschaltungen
113)
114)
115)

200 Geschoßboden
201 Pfeil
202 Aussparung
203 Schutzabdeckung

## Patentansprüche

1. Verpackung (10,100) von integrierten Schaltungen (5,6; 105-107), bei der die integrierten Schaltungen (5,6;105-107) zwischen zwei Folien (1,2;101-104) aus elastischem Material angeordnet sind und bei der die integrierten Schaltungen (5,6;105-107) mit zwischen den Folien (1,2;101-104) nach außen geführten elektrischen Leitungen (7,8) verbunden sind, **dadurch gekennzeichnet,** daß die beiden Folien (1,2;101-104) umfangseitig jeweils miteinander in einem Spannrahmen (3,4;108) befestigt sind, und daß die zwischen den Folien (1,2;101-104) nach außen geführten elektrischen Leitungen (7,8) direkt auf einer der beiden Folien (1,2;101-104) befestigt sind.

2. Verpackung nach Anspruch 1, **dadurch gekennzeichnet,** daß die Verpackung (100) mindestens drei übereinanderliegende Folien (101-104) aufweist, wobei in den Zwischenschichten jeweils eine Lage integrierter Schaltungen (105-107) vorgesehen ist.

3. Verpackung nach Anspruch 1 oder 2, **dadurch gekennzeichnet**, daß auf den den integrierten Schaltungen (105-107) zugewandten Seiten der Folien (101-104) Schichtschaltungen (110-115) aufgebracht sind, welche mit den integrierten Schaltungen (105-107) verbunden werden.

4. Verfahren zur Herstellung einer Verpakkung nach Anspruch 1, **gekennzeichnet durch** die Merkmale:
- die integrierten Schaltungen (5,6) werden auf eine erste Folie (1) aus elastischem Material aufgebracht und mit auf dieser Folie (1) befestigten nach außen geführten elektrischen Leitungen (7,8) verbunden;
- eine zweite Folie (2) aus elastischem Material wird auf die mit den integrierten Schaltungen (5,6) und elektrischen Leitungen (7,8) versehene erste Folie (1) gelegt;
- die beiden Folien (1,2) werden umfangseitig in einem Spannrahmen (3,4) eingespannt.

5. Verfahren nach Anspruch 4, **dadurch gekennzeichnet**, daß das Folieninnere vor dem Einspannen der Folien (1, 2) in dem Spannrahmen evakuiert oder mit einem inerten Gas gefüllt wird.

6. Verfahren nach Anspruch 4 oder 5, **dadurch gekennzeichnet**, daß die Folien (1, 2; 101-104) vor dem Aufbringen der integrierten Schaltungen (5, 6; 105-107) mit Schichtschaltungen (110-115) versehen werden, mit denen die integrierten Schaltungen (5, 6; 105-107) verbunden werden.

## Claims

1. Packaging (10,100) for integrated circuits (5,6; 105-107), in which the integrated circuits (5,6; 105-107) are arranged between two films (1,2; 101-104) of elastic material and in which the integrated circuits (5,6; 105-107) are connected with electric leads (7,8) extending outwards between the films (1,2; 101-104), characterised by the fact that the two films (1,2; 101-104) are in each case peripherally secured together in a clamping frame (3,4; 108) and that electric leads (7,8) extending outwards between the films (1,2; 101-104) are secured direct to one of the two films (1,2; 101-104).

2. Packaging in accordance with Claim 2, characterised by the fact that the package (100) has at least three films (101-104) situated one above the other, a layer formed by an integrated circuit (105-107) being in each case positioned between the intermediate layers.

3. Packing in accordance with Claim 1 or 2, characterised by the fact that laminated connections (110-115) are provided on those sides of the films (101-104) which face towards the integrated circuits (105-107) and are connected with the integrated circuits (105-107).

4. Process for the manufacture of a packaging in accordance with Claim 1, characterised by the following features:
- the integrated circuits (5,6) are placed on a first film (1) of elastic material and are connected with electric leads (7,8) which are affixed to the said film (1) and extended outwards;
- a second film (2) of elastic material is placed on the first film (1) provided with the integrated circuits (5,6) and electric leads (7,8);
- the two films (1,2) are peripherally clamped in a clamping frame (3,4).

5. Process in accordance with Claim 4, characterised by the fact that the interior of the film, before the films (1,2) are clamped into the clamping frame, is evacuated or filled with an inert gas.

6. Process in accordance with Claim 4 or 5, characterised by the fact that the films (1,2; 101-104) are provided, before mounting addition of the integrated circuits (5,6; 105-107), with laminated connections (110-115), through which the integrated circuits (5,6; 105-107) are connected.

## Revendications

1. Emballage (10, 100) de circuits intégrés (5, 6 ; 105 à 107), dans lequel les circuits intégrés (5, 6 ; 105 à 107) sont placés entre deux feuilles (1, 2 ; 101 à 104) en matériau élastique et dans lequel les circuits intégrés (5, 6 ; 105 à 107) sont reliés à des lignes électriques (7, 8) guidées vers l'extérieur entre les feuilles (1, 2 ; 101 à 104), caractérisé en ce que les deux feuilles (1, 2 ; 101 à 104) sont fixées périphériquement entre elles dans un cadre de serrage (3, 4 ; 108) et en ce que les lignes électriques (7, 8), guidées vers l'extérieur entre les feuilles (1, 2 ; 101 à 104) sont directement fixées sur l'une des deux feuilles (1, 2 ; 101 à 104),

2. Emballage selon la revendication 1, caractérisé en ce que l'emballage (100) comporte au moins trois feuilles (101 à 104) superposées, une couche de circuits intégrés (105 à 107) étant prévue dans chacune des couches intermédiaires.

3. Emballage selon les revendications 1 ou 2, caractérisé en ce que sur les faces des feuilles (101 à 104) tournées vers les circuits intégrés (105 à 107), sont appliqués des circuits en couche (110 à 115), qui sont reliés aux circuits intégrés (105 à 107).

4. Procédé de fabrication d'un emballage selon la revendication 1, caractérisé par les caractéristiques suivantes :
- les circuits intégrés (5, 6) sont appliqués sur une première feuille (1) en matière élastique et sont reliés à des lignes électriques (7, 8) guidées vers l'extérieur, fixées sur cette feuille (1) ;
- une seconde feuille (2) en matière élastique est placée sur la première feuille (1) pourvue des circuits intégrés (5, 6) et des lignes électriques (7, 8) ;
- les deux feuilles (1, 2) sont serrées périphériquement dans un cadre de serrage (3, 4).

5. Procédé selon la revendication 4, caractérisé en ce qu'avant serrage des feuilles (1, 2) dans le cadre de serrage, l'intérieur des feuilles est mis sous vide ou rempli d'un gaz inerte.

6. Procédé selon les revendications 4 ou 5, caractérisé en ce que les feuilles (1, 2 ; 101 à 104) sont pourvues, avant application des circuits intégrés (5, 6 ; 105 à 107), de circuits en couche (110 à 115) auxquels sont reliés les circuits intégrés (5, 6 ; 105 à 107).
